# EUROPÄISCHE PATENTSCHRIFT

(11) **EP 0 498 790 B1**
(45) Veröffentlichungstag und Bekanntmachung des Hinweises auf die Patenterteilung: **31.08.1994**
(21) Anmeldenummer: 92890027.3
(22) Anmeldetag: 04.02.1992
(51) Int. Cl.: H05K 5/04

(54) **Gestell mit modularem Aufbau zur Aufnahme von Leiterplatten und Baugruppen der Nachrichtentechnik**
Rack with modular construction for receiving circuit boards and sub-assemblies in telecommunication engineering
Baie avec construction modulaire pour la réception de plaques conductrices et d'ensembles de pièces de la technique des télécommunications

(30) Priorität: 05.02.1991 AT 241/91
(43) Veröffentlichungstag der Anmeldung: 12.08.1992
(73) Patentinhaber: Alcatel Austria Aktiengesellschaft, A-1210 Wien (AT)
(72) Erfinder: Eiweck, Julius, A-7082 Donnerskirchen (AT); Trimmel, Franz, A-1100 Wien (AT)

(56) Entgegenhaltungen:
- EP-A- 0 023 694
- EP-A- 0 123 133
- DD-A- 126 931
- DD-A- 269 514
- DE-A- 2 257 695
- DE-A- 2 556 048
- DE-C- 2 627 260
- DE-C- 2 656 943

## Beschreibung

Die Erfindung betrifft ein Gestell mit modularem Aufbau zur Aufnahme von Leiterplatten und Baugruppen der Nachrichtentechnik, bestehend aus mit Seitenblechen und Querträgern zusammengebauten, mechanisch eigenstabilen, Baugruppenträgern.

Üblicherweise sind Einrichtungen der Fernmeldetechnik in Schränken mit Rahmenkonstruktion untergebracht, wie sie beispielsweise aus der DD-PS 126 931 und der DE-PS 26 27 260 bekannt sind. Aus der DE-AS 26 56 943 ist auch ein Schrank bekannt, bei dem die Seitenwände aus mehreren, mit Hilfe von senkrecht durchgehenden Schienen zu einer Einheit zusammengebauten Teilen bestehen.

Alle diese Schränke dienen zur Aufnahme von Baugruppenträgern, wie sie beispielsweise aus der EPA 0023 694 bekannt sind.

Diese Baugruppenträger genügen an sich zur Unterbringung der fernmeldetechnischen Einrichtungen. Der zusätzliche Aufbau von Schränken bedeutet einen erheblichen Mehraufwand an Material und durch das zusätzliche Gewicht eine erhebliche zusätzliche Bodenbelastung.

In der DD-PS 269 514 wird daher ein Gestell vorgeschlagen, das aus einzelnen, mechanisch eigenstabilen, stapelbaren Gestellmodulen besteht. Diese Gestellmodule bestehen aus zwei Seitenteilen, die an ihren Hinterseiten durch zwei Profilschienen und an ihren Vorderseiten durch eine einleg- und verschraubbare Profilschiene miteinander verbunden sind. Die Seitenteile sind an ihren oberen und unteren Kanten schienenförmig und im Wechsel mit Ausnehmungen und Zapfen ausgebildet.

Nachteilig ist dabei, daß die Gestellmodule erst eigenstabil sind, wenn das gesamte Gestell fertig montiert ist. Es ist nicht möglich, die einzelnen Module vor allem im mit Leiterplatten bestückten Zustand zu transportieren.

Ein weiterer Nachteil besteht darin, daß zur Schaffung eines Kabelraumes seitliche, vordere und hintere Verschalungs- und Verblendungselemente angeordnet werden, die für unterschiedliche Gestellhöhen in jeweils unterschiedlichen Größen vorhanden sein müssen. Diese Tatsache schränkt die Modularität des Gestelles erheblich ein und erhöht die Anzahl der Lagerteile. Bei einer etwaigen Erweiterung um einen Modul müssen diese Elemente ausgetauscht werden.

Es ist nun Aufgabe der Erfindung ein Gestell nach der eingangs erwähnten Art zu schaffen, in der die Module durch ein Mindestmaß an zusätzlichen Bauteilen miteinander zu einer Einheit zusammengebaut werden können.

Die Erfindung löst diese Aufgabe dadurch, daß die Seitenbleche der Baugruppenträger jeweils an ihren Oberkanten Befestigungsbügel aufweisen, die mit den Unterkanten der Seitenbleche der jeweils darübergestapelten Baugruppen lösbar verbunden sind.

Durch die direkte Verbindung der Seitenteile miteinander sind keine weiteren Stützen oder Rahmenkonstruktionen erforderlich.

Die Befestigungsbügel können in einer sehr einfachen Weiterbildung der Erfindung an ihren Enden Winkel aufweisen, die die Befestigung von Abdeckelementen ermöglichen. Dabei entsteht zwischen den Seitenblechen und den seitlichen Abdeckelementen ein durch die Winkelabmessungen definierter Raum, der beispielsweise zur Aufnahme der Verkabelung dient.

Die Befestigungsbügel werden bei der Vorfertigung der bestückten Module auf die Oberkanten der Seitenteile geschraubt. Die so vorbereiteten Module können dann am Aufstellungsort in einfacher Weise übereinander gestapelt werden. Nach einer vorteilhaften Ausgestaltung der Erfindung weisen dabei die Seitenteile an ihren Unterseiten Befestigungslöcher auf, die als nach unten offene Schlitze ausgebildet sind. Durch diese Anordnung können auf den Befestigungsbügeln auch die Schrauben zur Befestigung des darüber zu stapelnden Moduls vorbereitend angebracht sein.

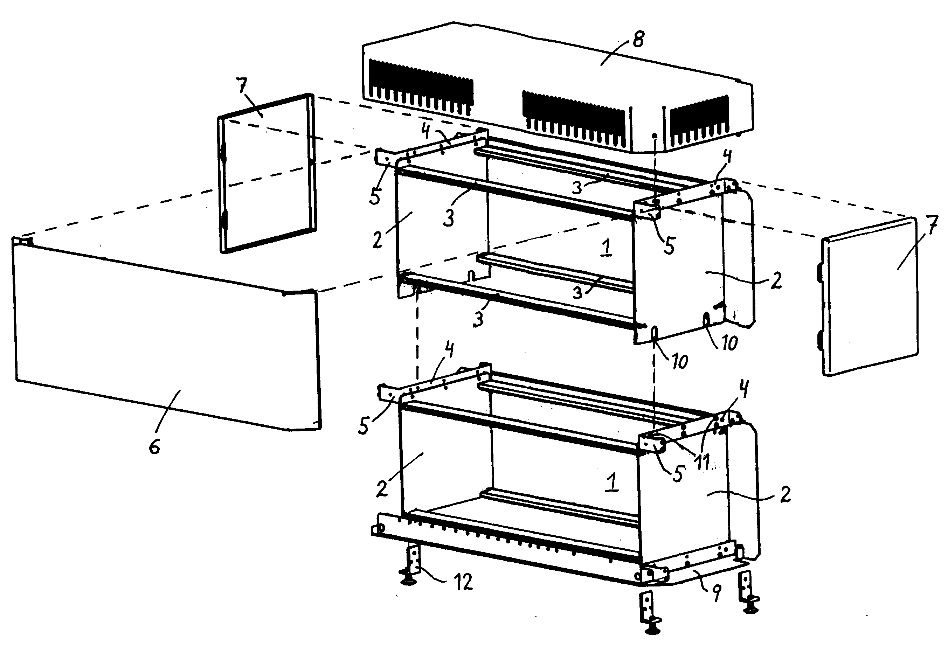

Die Erfindung wird nun anhand eines in der Zeichnung dargestellten Beispiels näher erläutert.

In der Fig. ist eine Zusammenstellungszeichnung eines Gestells dargestellt, das zwei Baugruppenträger 1 enthält, die jeweils aus zwei Seitenblechen 2, vier Querträgern 3 und einer Rückwand 13 bestehen. Die Seitenbleche 2 der übereinandergestapelten Baugruppenträger 1 sind mittels angeschraubter Befestigungsbügel 4 miteinander verbunden. Zum leichteren Aufeinanderstapeln enthalten die Seitenbleche 2 an ihren Unterseiten nach unten offene schlitzförmige Befestigungslöcher 10 in die die auf den Befestigungsbügeln 4 bereits vorbereiteten Schrauben eingeschoben werden können.

Die Befestigungsbügel 4 enthalten an ihren Enden einen Winkel 5 auf dem das vordere Abdeckelement 6 und die seitlichen Abdeckelemente 7 befestigt sind. Die Winkel 5 des obersten Baugruppenträgers 1 tragen auch noch das obere Abdeckelement 8 und jene des untersten Baugruppenträgers 1 das untere Abdeckelement 9.

Am untersten Baugruppenträger 1 sind weiters an den Seitenblechen 2 die Füße 12 befestigt.

In der Fig. sind wegen der Übersichtlichkeit nur die Abdeckelemente des oberen Baugruppenträgers dargestellt.

## Patentansprüche

1. Gestell mit modularem Aufbau zur Aufnahme von Leiterplatten und Baugruppen der Nachrichtentechnik, bestehend aus mit Seitenblechen (2) und Querträgern (3) zusammengebauten, mechanisch eigenstabilen, Baugruppenträgern (1), **dadurch gekennzeichnet**, daß die Seitenbleche (2) der Baugruppenträger (1) jeweils an ihren Oberkanten Befestigungsbügel (4) aufweisen, die mit den Unterkanten der Seitenbleche der jeweils darübergestapelten Baugruppen lösbar verbunden sind.

2. Gestell nach Anspruch 1, **dadurch gekennzeichnet**, daß die Befestigungsbügel (4) an ihren Enden Winkel (5) aufweisen, die die Befestigung von Abdeckelementen (6, 7, 8, 9) ermöglichen.

3. Gestell nach Anspruch 1 oder 2, **dadurch gekennzeichnet**, daß die Seitenbleche (2) an ihren Unterseiten Befestigungslöcher (10) aufweisen, die als nach unten offene Schlitze ausgebildet sind.

## Claims

1. Rack with modular construction for receiving circuit boards and subassemblies in telecommunication engineering, consisting of mechanically self-stable shelves being assembled with side sheets (2) and transverse girders (3), characterized in that the side sheets (2) of the shelves (1) at their upper edges contain fixing straps (4), which are disconnectably interconnected with the lower edges of the side sheets of the respectiv above stacked shelves.

2. Rack as claimed in claim 1, characterized in that the fixing straps (4) have angle bars (5) at their ends which make the fixing of cover elements (6,7,8,9) possible.

3. Rack as claimed in claim 1 or 2, characterized in that the side sheets (2) have fixing holes (10) at their lower sides which are designed as slots being open towards the bottom.

## Revendications

1. Baie de construction modulaire pour la réception de cartes à circuit imprimé et d'ensembles de la technique des télécommunications, constituée de porte-ensemble (1) mécaniquement auto-stables, composés de tôles latérales (2) et de traverses (3), caractérisée par le fait que les tôles latérales (2) des porte-ensemble (1) présentent chacune à leurs bords supérieurs, des étriers de fixation (4) qui sont reliés, de façcn amovible, aux bords inférieurs des tôles latérales de chacun des ensembles empilés par-dessus.

2. Baie selon la revendication 1, caractérisée par le fait que les étriers de fixation (4) présentent, à leurs extrémités, des équerres (5) qui permettent la fixation d'éléments de recouvrement (6, 7, 8, 9).

3. Baie selon la revendication 1 ou 2, caractérisée par le fait que les tôles lérales (2) présentent, à leurs bords inférieurs, des trous de fixation (10) qui sont conçus sous forme de fentes ouvertes vers le bas.
